Europäisches Patentamt

European Patent Office

Office européen des brevets

(19)

(11) Veröffentlichungsnummer: **0 017 296**
**B1**

(12) **EUROPÄISCHE PATENTSCHRIFT**

(45) Veröffentlichungstag der Patentschrift:
28.09.83

(51) Int. Cl.³: **C 03 C 17/02,** C 03 C 17/34,
G 02 B 7/26

(21) Anmeldenummer: 80200291.5

(22) Anmeldetag: 28.03.80

(54) Verfahren zur Herstellung von Mikrolinsen und Kopplungselement mit einer nach diesem Verfahren hergestellten Mikrolinse.

(30) Priorität: 06.04.79 DE 2913843

(43) Veröffentlichungstag der Anmeldung:
15.10.80 Patentblatt 80/21

(45) Bekanntmachung des Hinweises auf die Patenterteilung:
28.09.83 Patentblatt 83/39

(84) Benannte Vertragsstaaten:
AT BE DE FR GB IT NL SE

(56) Entgegenhaltungen:
FR-A-836 412
US-A-3 176 574
US-A-3 841 733
US-A-3 917 384
US-A-4 141 621
JOURNAL OF THE ELECTROCHEMICAL SOCIETY,
Band 121, Nr. 11, November 1974, The Electrochemical Society, Inc., Princeton, N.J., US C.M. WOLFE et al.: »Epitaxial growth of InxGal-x-As waveguide detectors for integrated optics«, Seiten 1506–1509
APPLIED OPTICS,
Band 13, Nr. 10, Oktober 1974, American Institute of Physics, Nes York, US; J.A. ARNAUD et al.:

(73) Patentinhaber: Philips Patentverwaltung GmbH, Steindamm 94, D-2000 Hamburg 1 (DE)
(84) Benannte Vertragsstaaten: DE

(73) Patentinhaber: N.V. Philips' Gloeilampenfabrieken, Groenewoudseweg 1, NL-5621 BA Eindhoven (NL)
(84) Benannte Vertragsstaaten: BE FR GB IT NL SE AT

(72) Erfinder: Franken, Adrianus Jacobus Josef, Pieter Zeemanstraat 6, NL-5621 CT Eindhoven (NL)
Erfinder: Khoe, Giok-Djan, Pieter Zeemanstraat 6, NL-5621 CT Eindhoven (NL)
Erfinder: Küppers, Dieter, Dr., Monheimsallee 27, D-5100 Aachen (DE)

(74) Vertreter: Plegler, Harald, Dipl.-Chem. et al, Philips Patentverwaltung GmbH Billstrasse 80 Postfach 10 02 29, D-2000 Hamburg 28 (DE)

»Guidance of surface waves by multilayer coatings«, Seiten 2343–2345
APPLIED PHYSICS LETTERS,
1. August 1979, American Institute of Physics, Band 35, Nr. 3, New York, US, A. NAUMAAN et al.: »A geodesic optical waveguide lens fabricated by anisotropic etching«, Seiten 234–236

Verfahren zur Herstellung von Mikrolinsen und Kopplungselement mit einer nach diesem
Verfahren hergestellten Mikrolinse

Die Erfindung bezieht sich auf ein Verfahren zur Herstellung von in einer Glasplatte eingebetteten Mikrolinsen. Unter Mikrolinsen sind Linsen mit einem Durchmesser <1 mm zu verstehen, insbesondere Linsen mit einem Durchmesser zwischen 20 und 100 µm. Linsen dieser Abmessungen werden z. B. in Kopplungselementen zum Koppeln von optischen Wellenleitern mit einer Lichtquelle oder zum Koppeln von optischen Wellenleitern untereinander verwendet. Die Linsen können aus einem Material mit konstantem Brechungsindex bestehen oder auch ein Brechungsindexprofil aufweisen.

Verfahren zur Herstellung von kugelförmigen Linsen, die für die genannten Zwecke angewendet werden können, sind an sich bekannt.

Aus der US-PS 3 666 347 ist ein Verfahren bekannt, bei dem zunächst homogene Glaskugeln mit dem gewünschten Durchmesser und mit einem hohen Brechungsindex hergestellt werden. Die Kugeln besitzen einen hohen Gehalt an Thalliumoxid. Die Kugeln werden in ein Salzbad von hoher Temperatur, das Kaliumionen enthält, gelegt. Durch Diffusion werden die Thalliumionen und die Kaliumionen gegeneinander ausgetauscht. Damit wird ein Brechungsindexprofil über den Durchmesser der Kugel erzeugt.

Mit diesem Verfahren ergibt sich ein durch Diffusion eingestelltes Profil, welches im allgemeinen nur eine Annäherung eines gewünschten Profils darstellen kann.

Aus der DE-OS 2 723 972 ist neben weiteren Austauschverfahren auch ein Verfahren zur Herstellung von kugelförmigen Linsen bekannt, bei dem Glaskeime mit sehr kleinem Durchmesser mit Schichten aus Oxidmischungen, deren Brechungsindex mit dem Durchmesser abnimmt, aus der Dampfphase beschichtet werden. Solche Schichten aus einer Mischung von Titandioxid und Siliziumdioxid können aus einer Atmosphäre, die Sauerstoff, Titantetrachlorid und Siliziumtetrachlorid enthält, wobei das $TiCl_4$-Verhältnis während der Beschichtung ständig kleiner gemacht wird, erhalten werden.

In der Praxis stellte es sich heraus, daß kaum vermeidbar ist, daß die Kugeln während der Beschichtung aneinanderstoßen, wenn mehrere Kugeln zugleich beschichtet werden. Dabei entstehen getrübte Schichten, wodurch die Transparenz der Linsen beeinträchtigt wird.

Die bekannten Verfahren liefern eine Anzahl von einzelnen Glaskugeln. Für die Anwendung in Kopplungselementen der eingangs genannten Art werden Kugeln mit einem Durchmesser in der Größenordnung des Lichtleiterkerndurchmessers benötigt. Kugeln dieser Art mit einem Durchmesser <100 µm sind nur in komplizierter Weise zu handhaben, und es sind spezielle Werkzeuge erforderlich, um sie für den genannten Zweck einsetzen zu können.

Aufgabe der Erfindung ist es, ein Verfahren zu schaffen, mit dem einfach handhabbare Mikrolinsen hergestellt werden.

Diese Aufgabe wird erfindungsgemäß gelöst, indem in einer Glasplatte mit dem Brechungsindex $n_1$ rotationssymmetrische Vertiefungen angebracht werden, dann mit einem Abscheidungsprozeß aus der Dampfphase glasartige Schichten mit einem Brechungsindex $n_2 \neq n_1$ auf der Platte abgeschieden werden, bis die Vertiefungen völlig ausgefüllt sind, wonach die Dicke der beschichteten Glasplatte auf den ursprünglichen oder einen kleineren Wert reduziert wird.

Mit dem Verfahren nach der Erfindung ist es ebenfalls möglich, Mikrolinsen mit einem profilierten Brechungsindexprofil herzustellen. Hierzu werden glasartige Schichten mit zunehmendem Brechungsindex auf der Glasplatte abgeschieden, z. B. aus dotiertem Quarzglas. Auf diese Weise kann das gewünschte Brechungsindexprofil, z. B. ein parabolisches Profil, erhalten werden. Die Glasplatte kann z. B. aus Quarzglas oder aus Glas bestehen.

Die rotationssymmetrischen Vertiefungen können auf verschiedene Weise in der Glasplatte hergestellt werden.

Die Vertiefungen können z. B. in die Glasplatte gebohrt oder eingeätzt werden. Beim Ätzverfahren wird auf der Platte zuerst mittels eines Photolackes eine Maske angebracht. Im nächsten Schritt wird geätzt. Dieses Ätzen kann entweder mittels der bekannten naßchemischen Verfahren oder mit Hilfe des Plasmaätzens erfolgen. Es ist darauf zu achten, daß das Ätzen isotrop erfolgt. Im darauffolgenden Schritt wird der Photolack entfernt. Eine weitere Möglichkeit ist das Einbrennen der Vertiefungen durch starkes lokales Erhitzen und Verdampfen des Materials mittels eines Lasers. Weiter ist es möglich, die Vertiefungen bei erhöhter Temperatur mit Hilfe einer Matrize in das erweichte Glas einzupressen.

Zur Herstellung von Mikrolinsen mit einem parabolischen Brechungsindexprofil wird in vorteilhafter Weise eine Glasplatte mit halbkugelförmigen Vertiefungen verwendet.

Im nächsten Schritt des erfindungsgemäßen Verfahrens werden aus der Dampfphase glasartige Schichten auf der Glasplatte abgeschieden. Dieses Abscheiden kann mittels eines CVD-Verfahrens, d. h. durch chemische Abscheidung aus der Dampfphase, erfolgen. Dabei wird die Zusammensetzung der Dampfphase nicht geändert, wenn es sich um die Herstellung von Linsen mit konstantem Brechungsindex handelt. Ein geeignetes Material ist z. B. $Si_3N_4$. Bei der Herstellung von Linsen mit einem Brechungsindexprofil wird mit Zunahme der Schichtdicke immer mehr Dotiermaterial zusammen mit Quarzglas abgeschieden, bis in der letzten Schicht der gewünschte Brechungsindex erreicht ist. Die Größe des zu erreichenden Brechungsindexunterschiedes kann die möglichen Dotierstoffe limitieren. Bei der Herstellung kugelförmiger Linsen erweisen sich z. B. $Si_3N_4$, $Sb_2O_3$ und andere Stoffe, mit denen Quarz dotiert werden kann und die einen Brechungsindex in der Größenordnung von 2 besitzen, als geeignet.

Für eine ideale kugelförmige Linse (Luneberglinse) ist ein exaktes parabolisches Brechungs-indexprofil der Form

$$n = [2 - (r/a)^2]^{\frac{1}{2}}$$

erforderlich. Diese Linse hat einen Brechungsindex $n = \sqrt{2}$ in der Mitte bei $r = 0$ und einen Brechungsindex von $n = 1$ bei $r = a$. Hierbei ist a der Radius der Kugel. Da es kein Glas mit dem Brechungsindex $n = 1$ gibt, strebt man eine Linse mit

$$n = n_0 [2 - (r/a)^2]^{\frac{1}{2}}$$

an, wobei $n_0 = 1,45$ der Brechungsindex von Quarzglas ist. Die Kugel hat in diesem Fall im Zentrum $n = 2,05$ und am Rand $n = 1,45$.

Bei dem Verfahren gemäß der Erfindung wird die Schicht vorzugsweise mit Hilfe des soge-nannten nichtisothermen Plasma-CVD-Verfah-rens aus der Gasphase abgeschieden. Unter einem »nichtisothermen Plasma-CVD-Verfahren« ist en Verfahren zu verstehen, bei dem mit einem sogenannten kalten Plasma gearbeitet wird, in dem nur Elektronen eine hohe kinetische Energie besitzen. Mit einem solchen Plasma kann man selbst Gasgemische zur Reaktion bringen, die thermisch nicht reaktiv sind. Weiter hat es sich gezeigt, daß sich mit dem nichtisothermen PCVD-Verfahren bei ziemlich niedriger Temperatur direkt aus der Gasphase glasartige Schichten abscheiden lassen, so daß sich eine nachfolgende Erhitzung zur Verglasung erübrigt, wie sie bei Verfahren, bei denen eine Glasrußschicht abgeschieden wird, notwendig ist. Ein weiterer Vorteil bei der Anwendung dieses Verfahrens ist, daß sich bei Abscheidung bei niedriger Temperatur, d. h. bei Temperaturen zwischen Raumtemperatur und 300°C, ein etwa-iger Unterschied in den Wärmeausdehnungsko-effizienten des Glasplattenmaterials und der abgeschiedenen Schichten nicht nachteilig bemerkbar macht.

Das Reduzieren der Dicke der beschichteten Glasplatte auf den ursprünglichen oder einen kleineren Wert erfolgt z. B. durch Abschleifen und/oder Polieren.

Zwei auf diese Weise hergestellte Linsen werden dann zu einer Linse vereinigt, indem die eingebetteten Linsen mit ihren flachen Seiten aneinandergelegt werden.

Die Erfindung wird anhand einer Zeichnung und einiger Ausführungsbeispiele näher erläutert. In der Zeichnung zeigt

Fig. 1 einen Teil einer Quarzglasplatte mit halbkugelförmigen Vertiefungen im Schnitt,
Fig. 2 eine beschichtete Platte im Schnitt,
Fig. 3 die Platte nach Fig. 2 nach dem Abpolieren im Schnitt,
Fig. 4a eine fertige kugelförmige Linse im Schnitt,
Fig. 4b eine fertige flache Linse im Schnitt,
Fig. 5 eine Beschichtungsvorrichtung in schematischer Darstellung,
Fig. 6 ein Kopplungselement in schematischer Darstellung.

Beispiel 1

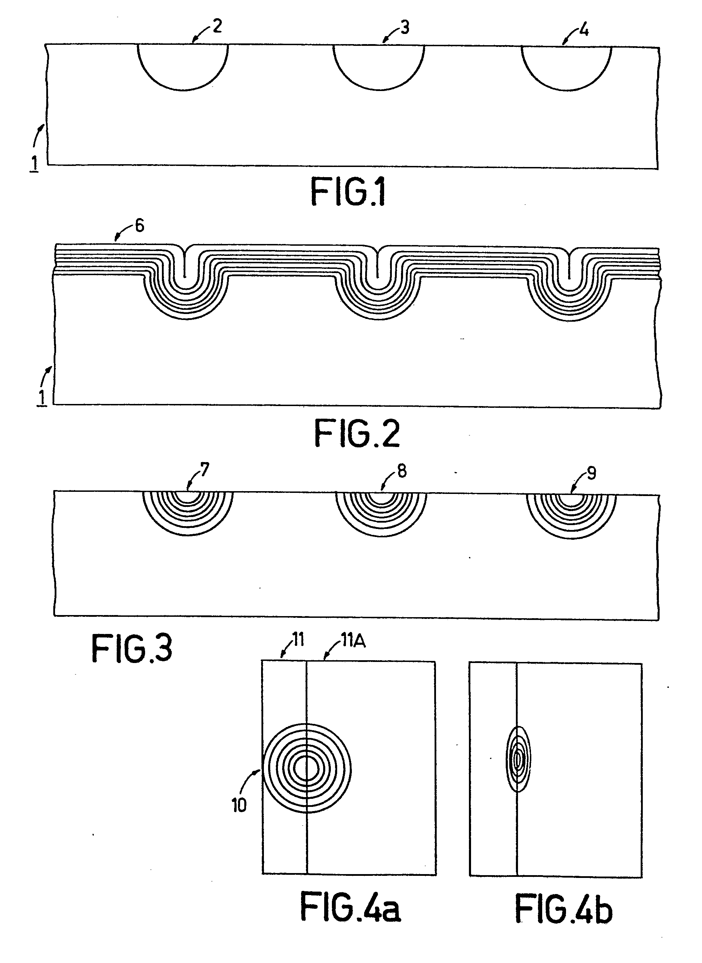

Mit Hilfe eines $CO_2$-Lasers werden in einer Quarzglasplatte 1 (30 mm × 30 mm, Dicke 1 mm) halbkugelförmige Vertiefungen 2, 3 und 4 mit einem Durchmesser von 70 μm angebracht (Fig. 1).

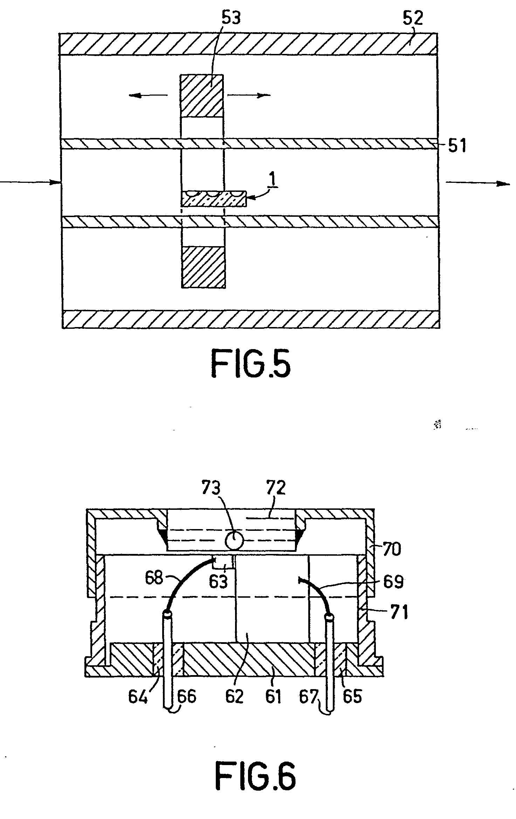

Dann wird die Platte 1 mit den halbkugelförmigen Löchern in ein Reaktionsrohr 51 gebracht (Fig. 5). Das Reaktionsrohr 51 befindet sich in einem elektrischen Ofen 52, in dem ein Mikrowellenresonator 53 entlang des Reaktionsrohres hin und her bewegt werden kann. Mit Hilfe eines nichtisothermen Plasmas wurde nun aus der Gasphase eine Schicht 6 aus $Si_3N_4$ mit einer Dicke von 35 μm auf der Platte abgeschie-den. Die Platte 1 befand sich während der Abscheidung auf einer Temperatur von einigen Hundert Grad Celsius. Der Druck im Reaktionsrohr 51 betrug etwa 6 mbar. Es wurde ein Gasgemisch aus $SiCl_4$ und $NH_3$ verwendet. Die Mengen der reagierenden Gase wurden Kubikzentimeter pro Minute von 0°C, 1000 mbar (= sccm: standard cubic centimeter per minute) gemessen. Sie betrugen für $SiCl_4$ 10 sccm und für $NO_2$ 0 bis 30 sccm. Das Plasma wurde mittels des Mikrowellenresonators 53 erzeugt, die angewendete Frequenz betrug 2,45 GHz. Die Schicht 6 bestand aus 1000 einzelnen Lagen, so daß jede Lage 0,035 μm dick war (Fig. 2), wobei in den Figuren nur einige Lagen dargestellt sind.

Die Dicke der Quarzglasplatte 1 wird dann durch Polieren auf den ursprünglichen Wert reduziert. Dadurch werden in Quarzglas integrierte halbkugelförmige Linsen (7, 8, 9) mit konstantem Brechungsindex erhalten (Fig. 3). Zwei Quarzglasplatten werden miteinander verbunden, so daß eine oder mehrere kugelförmige Linsen 10 eingebettet in Quarzglas 11—11A entstehen (Fig. 4a).

Der Abstand zwischen Linse 10 und Oberfläche der Quarzglasscheibe 11 kann durch Abpolieren auf einer Seite so gewählt werden, daß es der Brennweite der Linse 10 entspricht. Die Oberfläche der Scheibe 11 ist dann eine ausgezeichnete Referenz für die Ausrichtung der Lichtquelle. Poliert man die Quarzplatte weiter als auf den ursprünglichen Wert, so erhält man flache Linsen, deren Brennweiten je nach Krümmungsradius der Löcher und Brechungsindex der Füllungsmittel variierbar sind (Fig. 4b).

### Beispiel 2

In einem weiteren Versuch wurde eine Linse mit gradiertem Brechungsindexverlauf, eine sogenannte Luneberglinse, hergestellt. Die halbkugelförmigen Vertiefungen wurden dabei auf die gleiche Weise hergestellt wie in Beispiel 1. Der Versuchsaufbau zur Beschichtung, Druck, Temperatur usw. entsprachen ebenfalls denen des ersten Beispiels. Der Unterschied lag in der Art der verwendeten Gase und im zeitlichen Ablauf ihrer Zuführung. Es wurden $SiH_4$, $NH_3$ und $N_2O$ verwendet, wobei die Gasströmungen folgende Werte annahmen:

$SiH_4$:   10 sccm, konstant über die Versuchszeit,

$NH_3$:   0 bis 30 sccm, ansteigend über die Versuchszeit,

$N_2O$:   50 bis 0 sccm, abfallend über die Versuchszeit.

Das Verhältnis von N zu O in der Gasphase bei konstantem $SiH_4$-Gasstrom bestimmt das Verhältnis von $SiO_2$ zu $Si_3N_4$ im Niederschlag und damit den Brechungsindex. Es wurde ein parabolisches Brechungsindexprofil erzeugt. Dicke der Lage und die folgenden Schleifschritte waren wie im ersten Ausführungsbeispiel.

Die Erfindung bezieht sich weiter noch auf ein Kopplungselement mit einer Lichtquelle und einer Linse, wobei die Lichtquelle auf einem Träger befestigt ist, auf dem eine Kappe angeordnet ist, welche die Linse trägt. Eine in einer Glasplatte nach der Erfindung eingebettete Mikrolinse kleinster Abmessungen läßt sich in denkbar einfacher Weise in der Kappe relativ zu der Lichtquelle anordnen. In Fig. 6 ist schematisch eine Ausführungsform eines Kopplungselementes nach der Erfindung dargestellt. Auf einem metallischen Trägerteil 61 befindet sich ein Kupferblock 62, das als Wärmesenke funktioniert. Auf dem Block 62 ist ein Laserdiode 63 montiert. Der Träger 61 umfaßt weiter zwei Durchführungen 64 und 65 aus Glas mit darin angeordneten Anschlußstiften 66 und 67, die über Anschlußdrähte 68 bzw. 69 mit der Laserdiode 63 und mit dem Kupferblock 62 verbunden sind. Das Element umfaßt weiter eine Kappe 70 und einen Halter 71. In der Kappe 70 ist die Glasplatte 72 befestigt, z. B. mit einem Klebemittel. Die Glasplatte 72 enthält die kugelförmige Linse 73. Die Linse 73 ist so ausgerichtet, daß das Zentrum der Linse auf der Hauptachse des aus der Laserdiode 63 tretenden Lichtbündels liegt.

Das Verfahren nach der Erfindung ergibt die folgenden Vorteile:

1) Die Linse ist automatisch in einem Glasfenster integriert, welches einfach zu handhaben ist und für die Anwendung in einem hermetisch abgeschlossenen Kopplungselement direkt einsetzbar ist.

2) Mit Hilfe eines CVD-Prozesses, insbesondere eines nichtisothermen Plasma-CVD-Abscheidungsprozesses, ist durch geeignete Prozeßführung ein sehr genaues und nahezu beliebig einstellbares Brechungsindexprofil herzustellen.

3) Auf einer einzigen Glasplatte kann eine große Anzahl Vertiefungen und damit Mikrolinsen hergestellt werden.

4) Mit dem Verfahren nach der Erfindung können rotationssymmetrische Linsen beliebiger Formen und Brechungsindexprofile hergestellt werden.

### Patentansprüche

1. Verfahren zur Herstellung von in einer Glasplatte eingebetteten Mikrolinsen, dadurch gekennzeichnet, daß in einer Glasplatte mit dem Brechungsindex $n_1$ rotationssymmetrische Vertiefungen angebracht werden, dann mit einem Abscheidungsprozeß aus der Dampfphase glasartige Schichten mit einem Brechungsindex $n_2 \neq n_1$ auf der Platte abgeschieden werden, bis die Vertiefungen völlig ausgefüllt sind, wonach die Dicke der beschichteten Glasplatte auf den ursprünglichen oder einen kleineren Wert reduziert wird.

2. Verfahren nach Anspruch 1, dadurch gekennzeichnet, daß glasartige Schichten mit zunehmendem Brechungsindex abgeschieden werden.

3. Verfahren nach Anspruch 1, dadurch gekennzeichnet, daß in der Glasplatte halbkugelförmige Vertiefungen angebracht werden.

4. Verfahren nach Anspruch 1, dadurch gekennzeichnet, daß die glasartigen Schichten mittels eines nichtisothermen Plasma-CVD-Verfahrens aus der Gasphase abgeschieden werden.

5. Verfahren nach Anspruch 2, dadurch gekennzeichnet, daß Schichten aus Quarzglas mit einem zunehmenden Gehalt an Siliziumnitrid abgeschieden werden.

6. Verfahren zur Herstellung von Mikrolinsen, dadurch gekennzeichnet, daß zwei mit den Verfahren nach den Ansprüchen 1 bis 5 hergestellte Linsen zu einer Linse vereinigt werden, indem die eingebetteten Linsen mit ihren flachen Seiten aneinandergelegt werden.

7. Kopplungselement mit einer Lichtquelle und einer Linse, wobei die Lichtquelle auf einem Träger befestigt ist, auf dem eine Kappe angeordnet ist, welche die Linse trägt, dadurch gekennzeichnet, daß eine in einer Glasplatte (72) eingebettete Linse (73), die nach den Ansprüchen 1 bis 6 hergestellt worden ist, in der Kappe (70) angeordnet ist.

### Claims

1. A method of producing microlenses embedded in a glass plate, characterized in that rotationally symmetrical recesses are produced in a glass plate having a refractive index $n^1$, whereafter vitreous layers having a refractive index $n^2$, not equal $n^1$, are deposited on the plate by means of a vapour deposition process until the recesses have been completely filled, whereafter the thickness of the coated glass plate is reduced to the original value or to a lower value.

2. A method as claimed in Claim 1, characterized in that the vitreous layers are deposited with an increasing refractive index.

3. A method as claimed in Claim 1, characterized in that semispherical recesses are provided in the glass plate.

4. A method as claimed in Claim 1, characterized in that the vitreous layers are deposited by means of a non-isothermal plasma CVD-method from the gas phase.

5. A method as claimed in Claim 2, characterized in that layers of quartz glass having an increasing content of silicon nitride are deposited.

6. A method of producing microlenses, characterized in that two lenses produced by means of the method claimed in Claims 1 to 5 are combined to form one lens by placing the embedded lenses with their flat sides on top of one another.

7. A coupling element having a light source and a lens, the light source being fastened on a support on which a cap is provided which carries the lens, characterized in that a lens (73) which is embedded in a glass plate (72) and produced by means of the method claimed in Claims 1 to 6 is arranged in the cap (70).

**Revendications**

1. Procédé pour la fabrication de microlentilles noyées dans une plaque en verre, caractérisé en ce que des enfoncements à symétrie de révolution sont appliqués dans une plaque en verre présentant l'indice de réfraction n1 puis que des couches vitreuses présentant un indice de réfraction n2≠n1 sont déposées par un processus de dépôt à partir de la phase de vapeur sur la plaque jusqu'à ce que les enfoncements soient remplis, après quoi l'épaisseur de la plaque en verre recouverte de la couche est réduite jusqu'à la valeur initiale ou une valeur plus petite.

2. Procédé selon la revendication 1, caractérisé en ce que des couches vitreuses présentant un indice de réfraction accroissant sont déposées.

3. Procédé selon la revendication 1, caractérisé en ce que dans la plaque sont appliqués des enfoncements hémisphériques.

4. Procédé selon la revendication 1, caractérisé en ce que les couches vitreuses sont déposées par un procédé dépôt chimique de vapeur au plasma non isothermique à partir de la phase gazeuse.

5. Procédé selon la revendication 2, caractérisé en ce que des couches en verre de quartz présentant une teneur accroissante en nitrure de silicium sont déposées.

6. Procédé pour la fabrication de microlentilles, caractérisé en ce que deux lentilles fabriquées avec le procédé selon les revendications 1 à 5 sont réunies de façon à obtenir une seule lentille du fait que les lentilles noyées sont posées l'une contre l'autre par leurs faces planes.

7. Elément de couplage présentant une source lumineuse et une lentille, la source lumineuse étant fixée sur un support, sur lequel est fixée une coiffe supportant la lentille, caractérisé en ce qu'une lentille 73 noyée dans une plaque en verre 72 et réalisée selon les revendications 1 à 6 est appliquée dans la coiffe 70.

0 017 296

FIG.1

FIG.2

FIG.3

FIG.4a

FIG.4b

7

FIG.5

FIG.6